# EUROPEAN PATENT APPLICATION

(11) **EP 4 645 394 A1**
(43) Date of publication of application: **05.11.2025**
(21) Application number: 23909276.0
(22) Date of filing: 31.08.2023
(51) Int. Cl.: H01L 31/0224, H01L 31/068

(54) **SOLAR CELL AND SOLAR CELL SYSTEM**

(30) Priority: 30.12.2022 CN 202223591302 U
(71) Applicant: Trina Solar Co., Ltd., Changzhou, Jiangsu 213001 (CN)
(72) Inventor: XU, Guanchao, Hangzhou, Jiangsu 213001 (CN); ZHANG, Xueling, Hangzhou, Jiangsu 213001 (CN); CHEN, Yifeng, Hangzhou, Jiangsu 213001 (CN)
(74) Representative: Winter, Brandl - Partnerschaft mbB
(86) International application number: PCT/CN2023/116272
(87) International publication number: WO 2024/139338

(57) **Abstract**

The present application provides a solar cell and a solar cell system. The solar cell comprises a semiconductor substrate, a first emitter and a second emitter provided on the same side of the semiconductor substrate; and further comprising: a dielectric film layer covering the first emitter and the second emitter; a second emitter main busbar provided on the dielectric film layer; wherein the second emitter main busbar is electrically connected to the second emitter; the second emitter main busbar is stacked with the first emitter and is electrically isolated from the first emitter through the dielectric film layer. In the above technical solution, by providing the second emitter main gate stacked with the first emitter, the etching of the dielectric film layer can be reduced, and the preparation efficiency and speed of a solar cell can be enhanced.

## Description

### Technical Field

The present application relates to the technical field of photovoltaic panel, and particularly to a solar cell and a solar cell system.

### Background

The types of distributed photovoltaic installation mainly include BIPV photovoltaic roofs, solar canopy roofs, and flat roofs with tilted brackets, etc. The manners of fixing photovoltaic modules with waterproof rails commonly used in BIPV and tilted brackets are basically the same, and most of them use aluminum alloy clamping blocks paired with square nuts and bolts for fixation. The common fixing method for solar canopy roofs with rectangular steel pipes is to fix photovoltaic module frames from the underside by using clamping plates, or to secure photovoltaic modules by using back-lock holes and bolts to fasten the photovoltaic frame holes.

At present, U-shaped steel brackets should account for the largest proportion of installation types for photovoltaic projects in the market. Whether for a large-scale industrial and commercial roof project or a distributed small-scale roof project, this type of bracket holds a dominant position, especially for ground power stations, which are large in scale, short in construction periods, and require more manpower and material resources, resulting in significant labor costs for the installation of photovoltaic brackets and modules.

### Summary of the Invention

The present application provides a solar cell and a solar cell system for facilitating the fixation of photovoltaic modules.

The present application provides a solar cell, which comprises a semiconductor substrate, a first emitter and a second emitter provided on the same side of the semiconductor substrate; and further comprises:
a dielectric film layer covering the first emitter and the second emitter;
a second emitter main busbar provided on the dielectric film layer; wherein the second emitter main busbar is electrically connected to the second emitter; the second emitter main busbar is stacked with the first emitter and is electrically isolated from the first emitter through the dielectric film layer.

In the above technical solution, by providing the second emitter main gate stacked with the first emitter, the etching of the dielectric film layer can be reduced, and the preparation efficiency and speed of the solar cell can be enhanced.

In a specific implementable embodiment, the first emitter and the second emitter are located in the same layer.

In a specific implementable embodiment, the first emitter and the second emitter have different heights along the thickness direction of the semiconductor substrate.

In a specific implementable embodiment, it also comprises a second emitter fine grid; the second emitter main busbar is electrically connected to the second emitter through the second emitter fine grid.

In a specific implementable embodiment, the dielectric film layer is provided with a notch corresponding to the second emitter fine grid; and the second emitter fine grid is partially exposed outside the dielectric film layer and is conductively connected to the second emitter main busbar.

In a specific implementable embodiment, the length direction of the second emitter fine grid is perpendicular to the length direction of the second emitter main busbar.

In a specific implementable embodiment, it further comprises a first emitter fine grid, and the first emitter fine grid is electrically connected to the first emitter; wherein
the first emitter fine grid and the second emitter fine grid are alternately arranged along the length direction of the second emitter main busbar.

In a specific implementable embodiment, the second emitter is a strip-shaped emitter;
the number of the second emitters is plural, and a plurality of second emitters is arranged at an interval along the length direction of the second emitter main busbar.

In a specific implementable embodiment, the first emitter and the plurality of second emitters cover the surface of the semiconductor substrate; and the first emitter is located between the gaps of the plurality of second emitters.

In a second aspect, the present application provides a solar cell system, which comprises a bracket, and a solar cell according to any one of the above embodiments provided on the bracket.

### Brief description of the drawings

Figure 1 shows a top view of the solar cell provided in an embodiment of the present application;
Figure 2 shows a side view of the solar cell provided in an embodiment of the present application;
Figures 3 to 6 show the preparation process flowchart of the solar cell provided in an embodiment of the present application.

### Detailed Description

The present invention will be further explained in detail through the accompanying drawings and embodiments. Through these descriptions, the features and advantages of the present application will become more clearly defined.

The term "exemplary" used here means "serving as an example, embodiment, or illustration." Any embodiment described here as "exemplary" should not be interpreted as being superior or better than other embodiments. Although various aspects of the embodiments are shown in the drawings, they need not be drawn to scale unless specifically indicated.

Furthermore, the technical features in different embodiments of the present application described below can be combined with each other if they do not conflict.

For the convenience of understanding the solar cell provided in the embodiments of the present application, its application scenario will be firstly described. The solar panel provided in the embodiments of the present application is used to convert solar energy into electrical energy, which is the main direction of new energy at present. In order to improve the utilization efficiency of solar energy, current solar cells adopt full-back-contact solar cells. That is, two emitters are provided on the back of the solar cell.

Currently, when preparing a full-back-contact solar cell, it is necessary to prepare two emitters of different conductivity types on a substrate, and then prepare corresponding grid lines on the two emitters of different conductivity types. For the convenience of description, the two emitters are named as the first emitter and the second emitter, respectively. In the cell preparation process, the first emitter is prepared first, and then a dielectric film layer is prepared above it. When preparing the second emitter, it is necessary to etch off the dielectric film layer and a part of the prepared first emitter, and then prepare the second emitter in the etched area, and prepare the corresponding grid line structure on the second emitter. In the above preparation process, the time for ablating and etching the dielectric film layer at the grid line position is relatively long, accounting for about 30% of the entire process time, which greatly affects the production efficiency.

To this end, the embodiments of the present application provide a solar cell to improve the production efficiency of solar cell.

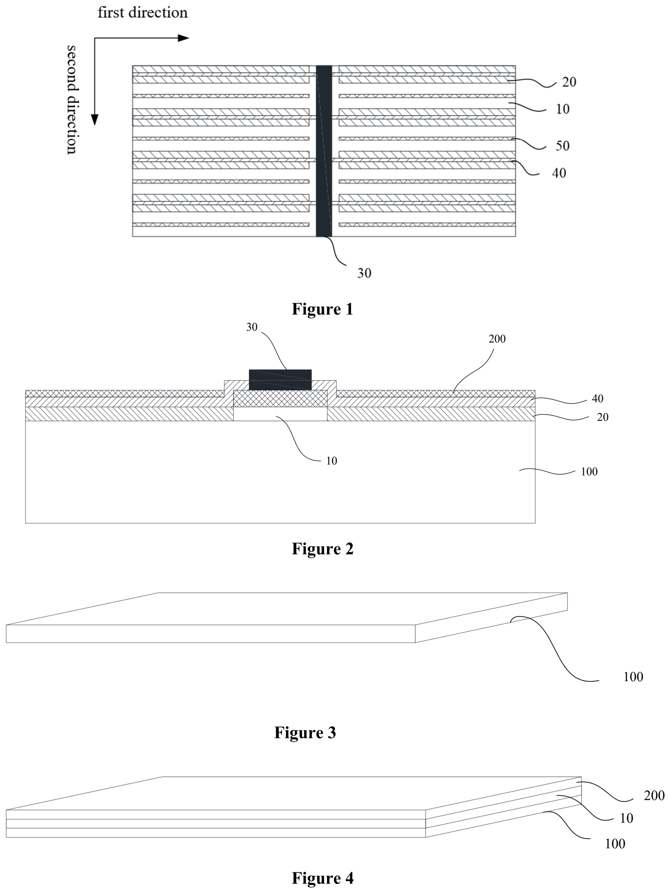

Referring to Figures 1 and 2, Figure 1 shows a top view of the solar cell provided in an embodiment of the present application. Figure 2 shows a side view of the solar cell provided in an embodiment of the present application. The solar cell provided in an embodiment of the present application mainly comprises a semiconductor substrate 100, a first emitter 10 and a second emitter 20. Among them, the conductivity types of the first emitter 10 and the second emitter 20 are different, and the conductivity type of the semiconductor substrate 100 is the same as that of one of the emitters.

For example, the first emitter 10 and the semiconductor substrate 100 are both of the first conductivity type, and the second emitter 20 is of the second conductivity type. Alternatively, the second emitter 20 and the semiconductor substrate 100 are both of the first conductivity type, and the first emitter 10 is of the second conductivity type. Among them, the first conductivity type is P-type, and the second conductivity type is N-type.

When providing the first emitter 10 and the second emitter 20, the first emitter 10 and the second emitter 20 are located on the same side of the semiconductor substrate 100. In the specific preparation, the first emitter 10 and the second emitter 20 are located on the back side of the semiconductor substrate 100. Among them, the back side of the semiconductor substrate 100 refers to the side of the semiconductor substrate 100 that faces away from solar light.

The emitters involved in the embodiments of the present application all comprise a tunneling layer and a doped polysilicon layer. The terms "first" and "second" in the first emitter 10 and the second emitter 20 in the embodiments of the present application are only defined for the convenience of description. The structures of both emitters use the above-mentioned tunneling layer and doped polysilicon layer.

Continuing with reference to Figure 1 and Figure 2, when providing the first emitter 10 and the second emitter 20 specifically, both the first emitter 10 and the second emitter 20 are prepared on the semiconductor substrate 100.

Referring to Figure 3 and Figure 4 together, Figures 3 and 4 show the preparation process flowchart of solar cell. In specific preparation, a first emitter 10 is prepared on a semiconductor substrate 100, firstly, and then a dielectric film layer 200 is prepared on the first emitter 10. The dielectric film layer 200 is an insulating dielectric film layer and is used to protect the first emitter 10.

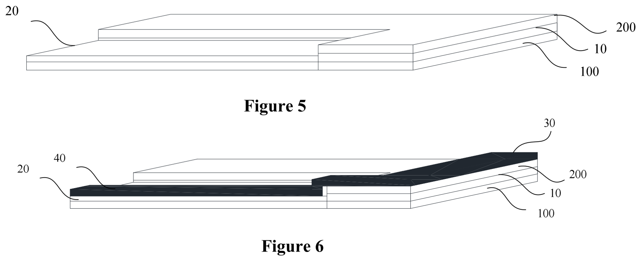

Referring to Figure 5, after preparing the dielectric film layer 200, the dielectric film layer 200 and the first emitter 10 are etched in the area where the second emitter 20 is to be formed, so that the semiconductor substrate 100 is exposed. Subsequently, the second emitter 20 is prepared on the exposed semiconductor substrate 100.

The first emitter 10 and the second emitter 20 mentioned above are located in the same layer, which refers to both the first emitter 10 and the second emitter 20 being prepared on the same surface of the semiconductor substrate 100. Exemplarily, the first emitter 10 and the second emitter 20 have different heights along the thickness direction of the semiconductor substrate 100. That is, the dimensions of the prepared first emitter 10 and the prepared second emitter 20 along the thickness direction of the semiconductor substrate 100 may not be the same, for example, the height of the second emitter 20 is lower than that of the first emitter 10.

Continuing with reference to Figure 1, for the convenience of illustration, the first emitter 10 and the second emitter 20 are shown in Figure 1. When forming the second emitter 20, the second emitter 20 is a strip-shaped structure. In addition, the number of the second emitters 20 can be plural, such as two, three, four, or other different numbers. It should be understood that when using the above structure, the first emitter 10 and the plurality of second emitters 20 cover the surface of the semiconductor substrate 100, and the first emitter 10 is located between the gaps of the plurality of second emitters 20. Thereby, the surface of the semiconductor substrate 100 is fully utilized.

When specifically providing a plurality of second emitters 20, a plurality of second emitters 20 are arranged at an interval. Among them, when arranging the plurality of second emitters 20, the arrangement direction of the second emitters 20 is perpendicular to the length direction of the second emitters 20. A first direction and a second direction are defined for the convenience of description. Among them, the first direction is parallel to one side of the semiconductor substrate 100, the second direction is parallel to the other side of the semiconductor substrate 100, and the first direction and the second direction are perpendicular to each other. Among them, the length direction of the second emitter 20 is parallel to the first direction, and the arrangement direction of the plurality of second emitters 20 is parallel to the second direction.

The solar cell provided in embodiments of the present application further comprises a first gate structure and a second gate structure. Among them, the first gate structure and the second gate structure serve as the peripheral circuit of the solar cell, which are used to transmit the electric energy generated by the solar cell. In a specific configuration, the first gate structure is conductively connected to the first emitter 10, and the second gate structure is conductively connected to the second emitter 20, in order to transmit the electric energy of the solar cell.

Continuing with reference to FIG. 1, when preparing the first gate structure, the first gate structure comprises a first emitter fine grid 50 and a first emitter main busbar (not shown in FIG. 1) connected to the first emitter fine grid 50. Among them, the first emitter fine grid 50 and the first emitter main busbar are both used as conductive structures to conductively connect the first emitter 10 to an external circuit. In specific preparation, the first emitter fine grid 50 is stacked with the first emitter 10 and located on the side of the first emitter 10 that faces away from the semiconductor substrate 100; the first emitter main busbar is stacked with the first emitter 10 and located on the side of the first emitter 10 that faces away from the semiconductor substrate 100. In addition, the first emitter fine grid 50 is also electrically connected to the first emitter main busbar. When connected to an external circuit, the first emitter main busbar is connected to the external circuit, and the electric energy generated by the solar cell is transmitted to the external circuit through the first emitter main busbar. It should be understood that the external circuit in the present application refers to a circuit outside the solar cell, and the external circuit can be different circuits such as the power grid or energy storage circuit.

It should be understood that in the preparation of the solar cell, after forming the first emitter 10, the first emitter fine grid 50 and the first emitter main busbar mentioned above can be prepared on its surface, and after preparing the first emitter fine grid 50 and the first emitter main busbar, the dielectric film layer 200 is formed.

Referring to Figure 1 and Figure 2 together, when preparing the second gate structure, the second gate structure comprises a second emitter main busbar 30, which is electrically connected to the second emitter 20 in order to cooperate with the first emitter main busbar to transmit the electricity generated by the solar cell to the external circuit.

When providing the second emitter main busbar 30 specifically, the second emitter main busbar 30 is provided on the dielectric film layer 200. Specifically, the second emitter main busbar 30 is on the dielectric film layer 200, that is, located on the side of the dielectric film layer 200 that faces away from the semiconductor substrate 100. In addition, the second emitter main busbar 30 is stacked with the first emitter 10, and the arrangement position of the second emitter main busbar 30 corresponds to the arrangement position of the first emitter 10. The wording "arrangement position ... corresponds to ..." means that the second emitter main busbar 30 is located above the first emitter 10 (on the side of the first emitter 10 that faces away from the semiconductor substrate 100). Exemplarily, using the surface of the semiconductor substrate 100, on which the first emitter 10 and the second emitter 20 are provided, as the reference plane, the vertical projection of the second emitter main busbar 30 on the reference plane is located within the projection range of the first emitter 10 on the reference plane.

When the second emitter main busbar 30 is stacked with the first emitter 10, in order to ensure electrical isolation between them and avoid short circuit, the second emitter main busbar 30 is electrically isolated from the first emitter 10 through the dielectric film layer 200.

Referring to Figure 2 and Figure 6, when preparing the second emitter main busbar 30, the second emitter main busbar 30 can be prepared on the dielectric film layer 200. Since the second emitter main busbar 30 is located above the first emitter 10, in the embodiments of the present application, only the dielectric film layer 200 at the position where the second emitter 20 is prepared needs to be etched. When preparing the second emitter main busbar 30, it can be prepared directly on the unetched dielectric film layer 200. In contrast, in the prior art, when stacking the second emitter main busbar 30 with the second emitter 20, it is necessary to etch off the position corresponding to the second emitter main busbar 30 and prepare the second emitter 20 on it. The solar cell provided in the embodiments of the present application can greatly reduce the amount of etching on the dielectric film layer 200, thereby reducing the time for preparing the solar cell and improving the preparation efficiency of the solar cell.

From the above description, it can be seen that the solar cell provided in the embodiments of the present application is arranged by stacking the second emitter main busbar 30 with the first emitter 10, thereby reducing the etching of the dielectric film layer 200 and enhancing the preparation efficiency and speed of solar cell.

Referring to Figure 1 together, when preparing the second emitter main busbar 30, the second emitter main busbar 30 is a strip-shaped structure. Moreover, the length direction of the second emitter main busbar 30 is along the second direction. That is, the length direction of the second emitter main busbar 30 is along the arrangement direction of the plurality of second emitters 20. In this case, it can be regarded that the plurality of second emitters 20 are arranged at an interval along the length direction of the second emitter main busbar 30.

Referring to Figure 1 and Figure 2 together, the second gate structure provided in the embodiments of the present application may further comprise a second emitter fine grid 40, which is used as a connection structure for connecting the second emitter main busbar 30 with the second emitter 20. Exemplarily, in a specific connection, the second emitter main busbar 30 is electrically connected to the second emitter 20 through the second emitter fine grid 40.

When providing the second emitter fine grid 40 specifically, the second emitter fine grid 40 is stacked with the second emitter 20, and they are directly conductively connected. Exemplarily, after preparing the second emitter 20, the second emitter fine grid 40 is directly prepared on the second emitter 20, and the second emitter fine grid 40 is located on the side of the second emitter 20 that faces away from the semiconductor substrate 100. After preparing the second emitter 20, the dielectric film layer 200 is prepared again to cover the second emitter 20 and the second emitter fine grid 40.

Exemplarily, a notch corresponding to the second emitter fine grid 40 is provided in the dielectric film layer 200 (the position of this notch can refer to the position where the second emitter fine grid 40 passes through the dielectric film layer 200); the second emitter fine grid 40 is partially exposed outside the dielectric film layer 200 and is conductively connected to the second emitter main busbar 30, in order to ensure that the end of the second emitter fine grid 40 which is exposed outside the dielectric film layer 200 is conductively connected to the second emitter main busbar 30.

When preparing the second emitter fine grid 40 specifically, the second emitter fine grid 40 is arranged to intersect with the second emitter main busbar 30, that is, the length direction of the second emitter fine grid 40 intersects with the length direction of the second emitter main busbar 30. As an example, the length direction of the second emitter fine grid 40 is perpendicular to the length direction of the second emitter main busbar 30. The perpendicular arrangement thereof facilitates the layout of the first gate structure and the second gate structure.

As an example, the number of the second emitter fine grid 40 is plural, and the plurality of second emitter fine grid is arranged at an interval along the second direction. In addition, in the embodiments of the present application, the second emitter fine grid 40 corresponds one-to-one with the second emitter 20. As shown in Figure 1, one second emitter fine grid 40 is arranged on one second emitter 20. Moreover, the length direction of the second emitter fine grid 40 is parallel to the length direction of the second emitter 20, that is, both extend along the first direction.

When the solar cell comprises the first emitter fine grid 50 and the second emitter fine grid 40, the first emitter fine grid 50 and the second emitter fine grid 40 are alternately arranged along the length direction of the second emitter main busbar 30. As shown in Figure 1, a plurality of first emitter fine grids 50 and a plurality of second emitter fine grids 40 are alternately arranged along the second direction. In addition, when providing the first emitter fine grid 50 and the second emitter fine grid 40, the first emitter fine grid 50 and the second emitter fine grid 40 are arranged in parallel to facilitate wiring.

It should be understood that when preparing the dielectric film layer 200, the dielectric film layer 200 covers the second emitter 20, and the dielectric film layer 200 covers the first emitter 10 and the second emitter 20 in order to protect the first emitter 10 and the second emitter 20.

The embodiment of the present application also provides a solar cell system, which comprises a bracket and any one of the above-mentioned solar cells provided on the bracket. In a specific configuration, the bracket supports the above-mentioned solar cell. When the solar cell is prepared in the above-mentioned manner, the second emitter main gate is stacked with the first emitter, thereby reducing the etching of the dielectric film layer and enhancing the preparation efficiency and speed of solar cell.

In the description of the present application, it should be noted that terms such as "upper," "lower," "inner," "outer," "front," "rear," "left," and "right" indicate the orientation or positional relationship based on the working state of the present application. These terms are used only to facilitate the description of the present application and to simplify the description, and do not indicate or imply that the device or components must have a specific orientation or be constructed and operated in a specific orientation. Therefore, they should not be construed as limiting the present application.

In the description of this application, it should be noted that unless otherwise explicitly specified and limited, the terms such as "install", "connect" and "link" should be interpreted broadly. Those skilled in the art can understand the specific meanings of these terms in the context of this application based on specific situations.

The above description combines preferred embodiments to explain the present application, but these embodiments are only exemplary and serve only illustrative purposes. On this basis, various substitutions and modifications can be made to the present application, all of which fall within the scope of protection of the application.

## Claims

1. A solar cell, **characterized in that**, comprising a semiconductor substrate, a first emitter and a second emitter provided on the same side of the semiconductor substrate; and further comprising:
a dielectric film layer covering the first emitter and the second emitter;
a second emitter main busbar provided on the dielectric film layer; wherein the second emitter main busbar is electrically connected to the second emitter; the second emitter main busbar is stacked with the first emitter and is electrically isolated from the first emitter through the dielectric film layer.

2. The solar cell according to claim 1, **characterized in that**, the first emitter and the second emitter are located in the same layer.

3. The solar cell according to claim 1, **characterized in that**, the first emitter and the second emitter have different heights along the thickness direction of the semiconductor substrate.

4. The solar cell according to claim 1, **characterized in that**, further comprising a second emitter fine grid; the second emitter main busbar is electrically connected to the second emitter through the second emitter fine grid.

5. The solar cell according to claim 4, **characterized in that**, the dielectric film layer is provided with a notch corresponding to the second emitter fine grid; the second emitter fine grid is partially exposed outside the dielectric film layer and is conductively connected to the second emitter main busbar.

6. The solar cell according to claim 5, **characterized in that**, the length direction of the second emitter fine grid is perpendicular to the length direction of the second emitter main busbar.

7. The solar cell according to claim 4, **characterized in that**, further comprising a first emitter fine grid electrically connected to the first emitter; wherein
the first emitter fine grid and the second emitter fine grid are alternately arranged along the length direction of the second emitter main busbar.

8. The solar cell according to any one of claims 1 to 7, **characterized in that**, the second emitter is a strip-shaped emitter;
the number of the second emitter is plural, and a plurality of second emitters is arranged at an interval along the length direction of the second emitter main busbar.

9. The solar cell according to claim 8, **characterized in that**, the first emitter and the plurality of second emitters cover the surface of the semiconductor substrate; and the first emitter is located between the gaps of the plurality of second emitters.

10. A solar cell system, **characterized in that**, comprising a bracket, and a solar cell according to any one of claims 1 to 9 provided on the bracket.
